# EUROPÄISCHE PATENTANMELDUNG

(11) **EP 1 460 447 A1**
(43) Veröffentlichungstag der Anmeldung: **22.09.2004**
(21) Anmeldenummer: 03024834.8
(22) Anmeldetag: 31.10.2003
(51) Int. Cl.: G01R 35/00, G01R 31/36

(54) **Verfahren und Vorrichtung zur Fehlersuche in elektronischen Mess- und Prüf-Anordnungen für galvanische Elemente**

(30) Priorität: 20.03.2003 DE 10313786
(71) Anmelder: VARTA Microbattery GmbH, 30419 Hannover (DE)
(72) Erfinder: Hald, Rainer, 73479 Ellwangen (DE); Haug, Peter, Dr., 73479 Ellwangen (DE); Ilic, Dejan, Dr., 73479 Ellwangen (DE); Wallkum, Willi, 73495 Stödtlen (DE); Birke, Peter, Dr., 73479 Ellwangen (DE)
(74) Vertreter: Patentanwälte Ruff, Wilhelm, Beier, Dauster & Partner

(57) **Zusammenfassung**

Bei einem Verfahren zur Fehlersuche in automatisch arbeitenden elektronischen Meß- und Prüf-Anordnungen für eine Vielzahl von galvanischen Elementen werden in die für die galvanischen Elemente vorgesehenen Halterungen Zellsimulatoren (9) eingesetzt. Diese Zellsimulatoren (9) simulieren in äußerer Form und Größe einschließlich der elektrischen Anschlüsse ein galvanisches Element. Sie enthalten eine Prüfelektronik (6, 7), deren Verhalten sich bei inverser Polarität stark vom Verhalten bei anwendungsrichtiger Polarität unterscheidet. Ein Zellsimulator wird aktiviert und mit einem Meßstrom beaufschlagt. Anschließend wird die Spannung bzw. Spannungsantwort am Zellsimulator gemessen und mit dem für diesen Zellsimulator (9) vorgegebenen Sollspannungswert verglichen. Die Prüfelektronik besteht zumindest aus der Parallelschaltung eines Widerstands (7) und einer Diode (6).

## Beschreibung

Gegenstand der Erfindung ist ein Verfahren zur Fehlersuche in automatisch arbeitenden elektronischen Meß- und Prüf-Anordnungen für eine Vielzahl von galvanischen Elementen sowie eine Vorrichtung, die insbesondere zur Durchführung dieses Verfahrens geeignet ist.

Wiederaufladbare galvanische Elemente, insbesondere Lithiumzellen, enthalten in vielen Fällen einen Zellenstapel, der aus mehreren Einzelelementen besteht. Die Einzelzellen oder Einzelelemente, aus denen ein solcher Zellenstapel zusammengesetzt ist, sind ein Laminat, das aus Ableitern, aktivem Elektrodenfilm und Separator erzeugt wird. Derartige Laminate aus fest verbundenen Einzelteilen werden insbesondere als sogenannte Bizellen mit den möglichen Sequenzen negative Elektrode/Separator/positive Elektrode/Separator/negative Elektrode oder positive Elektrode/Separator/negative Elektrode/Separator/positive Elektrode hergestellt.

In der US-PS 5,460,904 sind Verfahren zur Herstellung von solchen wiederaufladbaren Lithium-lonenbatterien beschrieben. Mehrere Bizellen werden zu einem Stapel aufgeschichtet, der nach Einlegen in einen Behälter aus beispielsweise tiefgezogener Aluminiumverbundfolie, Befüllen mit Elektrolyt, Versiegeln mit einem Deckel, Formation und Endverschluß zu einer fertigen Batterie verarbeitet wird.

In der Batterieindustrie werden zur elektrischen Prüfung von Batterien hochautomatisierte Meßeinrichtungen verwendet. Im Bereich wiederaufladbarer Batterien sind diese Anlagen auch in der Lage, die Batterien zu formieren, indem ein oder mehrere Lade-Entlade-Zyklen durchfahren werden. Um hohe Durchsätze zu erreichen, sind diese Anlagen im allgemeinen vollautomatisiert.

Die Formation einer großen Anzahl von galvanischen Elementen erfordert aufwendige Vorrichtungen, in denen die Ableiter der Zellen während der Formation elektrisch kontaktiert und die Zellen gehaltert werden. Im allgemeinen wird eine Vielzahl von Flachzellen nebeneinander in Ausnehmungen einer Halterung, einem sogenannten Formationstray, eingesetzt, wobei die Ausnehmungen dem Zellenquerschnitt angepasst sind. Dabei weisen die Ableiterfahnen der Flachzellen in eine Richtung und sind beispielsweise zwischen plattenförmigen Kontaktfedern, die auf Trägervorrichtungen angeordnet sind, eingeklemmt. Die Kontaktierung der Ableiterfahnen kann aber auch durch Aufdrücken von Kontaktstiften erfolgen.

Bei der Prüfung der Batterieeigenschaften werden die Batterien seriell, also nacheinander, gemessen, wobei die Prüfdauer in der Regel unter 1 Sekunde liegt. Länger dauernde Prüfungen oder Behandlungen werden allerdings mit mehreren Batterien parallel, also gleichzeitig, durchgeführt. Dazu werden die Batterien in spezielle Behälter eingebracht und automatisch oder von Hand der entsprechenden Anlage zugeführt. Diese Anlagen sind im allgemeinen computergesteuert. Defekte Batterien werden automatisch aussortiert. Die Prüfung oder Behandlung erfolgt mit konstanten Strömen oder Strompulsen und/oder konstanten Spannungen. Eine derartige Vorrichtung ist beispielsweise aus der DE 102 13 685.8 A1 bekannt.

Die Kontaktierungseinrichtungen sind entsprechend der Zahl der Batterien mit Anschlußkabeln versehen und besitzen vier Anschlüsse pro Zelle. In Anlagen zur Formierung von Batterien werden meist mehrere tausend oder zehntausend Batterien gleichzeitig bearbeitet. Jede einzelne Batterie ist mit einem Kanal der Steuer-, Meß- und Regelelektronik verbunden. Bei der dadurch bedingten großen Anzahl von Kabeln und Steuerungselektronikkanälen kann es sowohl bei der Installation als auch im laufenden Betrieb zu Fehlern kommen.

Eine von Hand vorgenommene Prüfung der Anschlüsse beim Aufbau der Anlage ist sehr aufwendig. Sie erfordert viel Zeit und Arbeit unter schwierigen Bedingungen. Während des Betriebs können Fehler oftmals nicht detektiert werden und es kommt so zu Fehlmessungen bzw. Fehlbehandlungen.

### Aufgabe und Lösung

Aufgabe der vorliegenden Erfindung ist, ein Verfahren anzugeben und eine Vorrichtung, die insbesondere zur Durchführung des Verfahrens geeignet ist, die eine einfache, schnelle und vollautomatisierbare Fehlersuche und eine vorbeugende Problemerkennung ermöglicht.

Diese Aufgabe wird erfindungsgemäß durch ein Verfahren mit den Merkmalen des Anspruchs 1 und eine Vorrichtung mit den Merkmalen des Anspruchs 4 gelöst. Vorteilhafte sowie bevorzugte Ausgestaltungen der Erfindung sind Gegenstand der weiteren Ansprüche und werden im folgenden näher erläutert. Der Wortlaut der Ansprüche wird durch ausdrückliche Bezugnahme zum Inhalt der Beschreibung gemacht.

Erfindungsgemäß werden in die für die galvanischen Elemente vorgesehenen Halterungen bzw. Formationstrays Zellsimulatoren eingesetzt, die in äußerer Form und Größe einschließlich der elektrischen Anschlüsse ein galvanisches Element simulieren bzw. nachbilden und die eine Prüfelektronik enthalten, deren Verhalten sich bei inverser Polarität stark vom Verhalten bei anwendungsrichtiger Polarität unterscheidet. Jeweils ein Zellsimulator wird aktiviert und mit einem Meßstrom beaufschlagt, wobei anschließend die Spannung bzw. Spannungsantwort am Zellsimulator gemessen wird und mit einem für diesen Zellsimulator vorgegebenen Sollspannungswert oder einer Sollspannungsantwort verglichen wird. Dies kann beispielsweise in vorgegebenen Zeitabständen erfolgen.

Die Zellsimulatoren enthalten eine Prüfelektronik, die zumindest aus der Parallelschaltung eines Widerstands und einer Diode bestehen kann. Vorteilhaft sind mehrere Zellsimulatoren nebeneinander oder benachbart angeordnet. Sie können dabei jeweils leicht voneinander abweichend ausgebildet sein, beispielsweise im Verhalten bzgl. der Spannungsantwort unterschiedliches Verhalten aufweisen. Dies kann beispielsweise durch unterschiedliche Impedanzen realisiert werden. So kann eine Unterscheidung zwischen den einzelnen Zellsimulatoren leicht erfolgen.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränken die unter diesen gemachten Aussagen nicht in ihrer Allgemeingültigkeit.

### Kurzbeschreibung der Zeichnungen

Im folgenden ist der Gegenstand der Erfindung anhand der schematischen Figuren näher erläutert. In den Figuren zeigen:
- Figur 1: einen erfindungsgemäßen Zellsimulator,
- Figur 2: die elektrische Verschaltung der Vorrichtung und
- Figur 3: in einem schematischen Schaltplan verschiedene Fehler, die vom erfindungsgemäßen Verfahren erkannt werden.

### Detaillierte Beschreibung der Ausführungsbeispiele

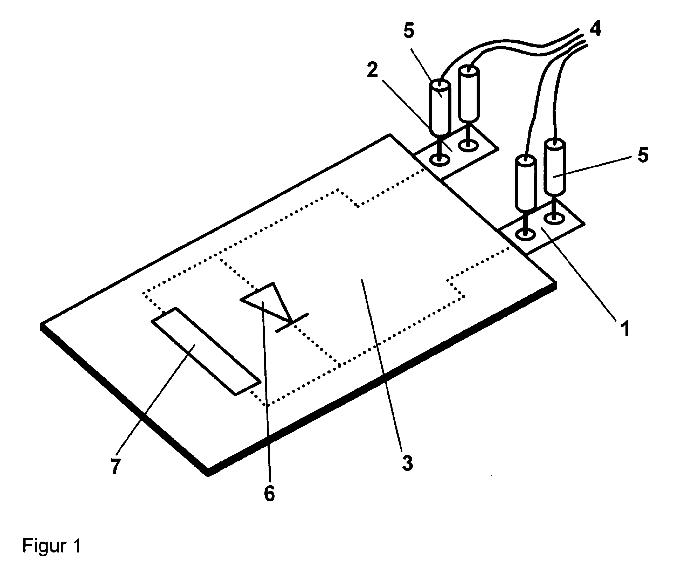

Figur 1 zeigt schematisch den Aufbau eines Zellsimulators 9. Dieser besteht aus einer Leiterplatte 3, welche die Prüfelektronik enthält, die zumindest aus der Parallelschaltung eines Widerstands 7 und einer Diode 6 besteht. Des weiteren enthält der Zellsimulator 9 den positiven Ableiter 1 sowie den negativen Ableiter 2. Die Ableiter sind über vier Kontaktstifte 5, die in einer Leitung 4 zusammengefasst sind, mit einer Stromversorgung und einer Prüfvorrichtung verbunden. Anstelle der Kontaktstifte kann die Kontaktierung der Ableiter auch über beidseitig angebrachte Kontaktfedern erfolgen. Die beiden Ableiter können z. B. aus einem 100 µm dicken und 5 mm breiten Nickelband bestehen und sind z. B. durch einen Lötprozeß mit den Leiterbahnen der Prüfelektronik auf der Leiterplatte verbunden. Die Abmessungen des Zellsimulators in äußerer Form und Größe entsprechen dem zu prüfenden oder zu formierenden galvanischen Element.

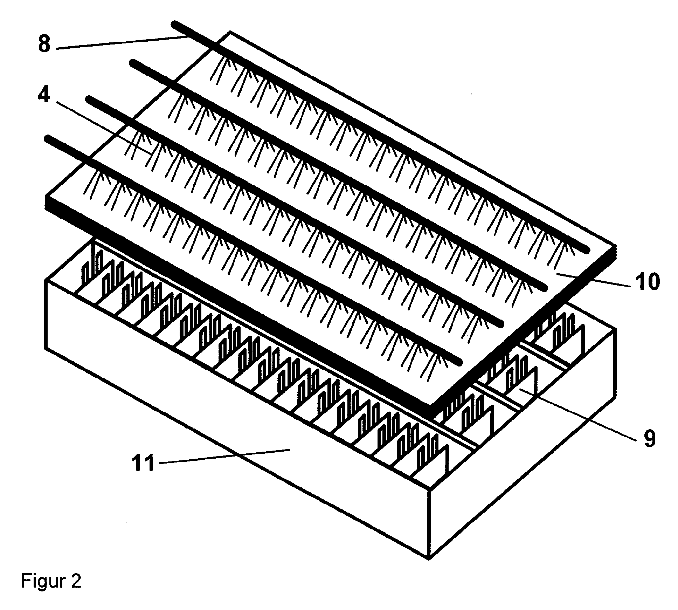

Figur 2 zeigt ein sogenanntes Formationstray 11, das als Halterung für eine Vielzahl von nebeneinander angeordneten Flachzellen bzw. Zellsimulatoren 9 dient. Die einzelnen Flachzellen sind dabei in Ausnehmungen in der Halterung angeordnet, die dem Zellenquerschnitt angepasst sind.

Die Kontaktiereinheit 10 enthält die Kontaktstifte 5 bzw. die Kontaktfedern zur Kontaktierung der Zellen bzw. Zellsimulatoren 9. Die Kontaktstifte 5 bzw. die Kontaktfedern sind mit den im Kabelbaum 8 zusammengefaßten Leitungen 4 verbunden.

Die in einer Formationsanlage vorhandenen Formationsplätze sind in logische Blöcke unterteilt. Es können z. B. 24.576 Plätze in 192 Blöcken zu je 128 Plätzen vorhanden sein. Jeder Block entspricht einem Anlagenfach zur Aufnahme eines Formationstrays 11. Jedes Anlagenfach enthält eine Kontaktiereinheit 10 zur Kontaktierung der Zellen eines Formationstrays. Pro Zelle werden vier elektrische Verbindungen 4 zur Steuer- und Regelelektronik der Anlage hergestellt. Jeder Kanal der Steuerung ist mit einer Zelle oder einem Zellsimulator 9 verbunden.

Ein mit den oben beschriebenen Zellsimulatoren bestücktes Formationstray wird z. B. durch ein Regalbediengerät in das zu prüfende Anlagenfach eingebracht. Danach werden die Zellsimulatoren durch Schließen der Kontaktiereinheit mit der Steuerung elektrisch verbunden.

Für die erfindungsgemäße Fehlersuche ist es wesentlich, daß benachbarte Zellsimulatoren unterschiedliches Verhalten aufweisen, um z. B. vertauschte Leitungen zwischen benachbarten Kanälen bzw. Zellen zu erkennen. Da ein Vertauschen der Leitungen von bis zu vier benachbarten Kanälen möglich ist, werden vier verschiedene Zellsimulatoren in sich regelmäßig wiederholender Weise angeordnet, wie in Figur 2 verdeutlicht wird.

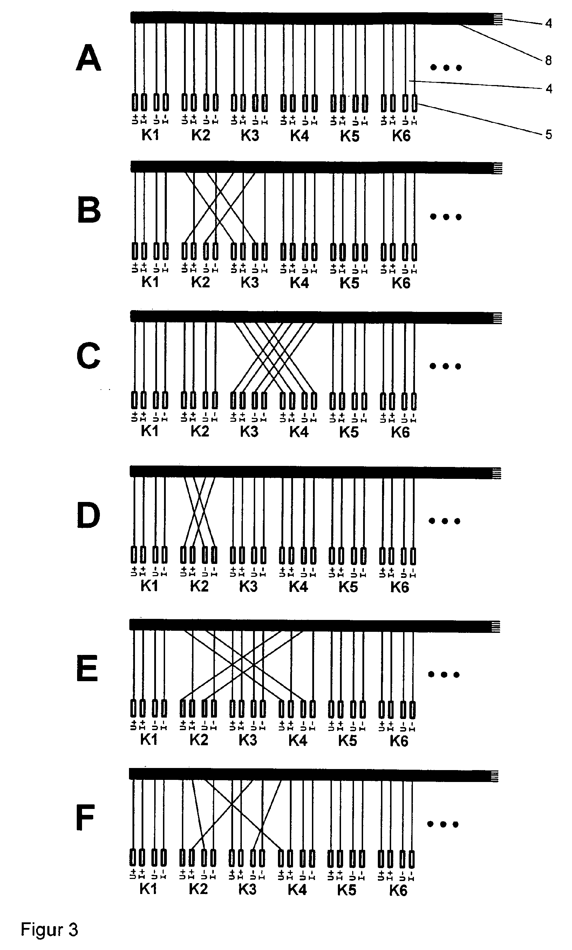

Figur 3A zeigt schematisch die zu einem Kabelbaum 8 zusammengefaßten Leitungen 4 und die jeweils vier Kontaktierungen 5 pro Zelle oder Zellsimulator. Von jedem Kanal der Steuerelektronik führen vier Leitungen (U+, U-, I+, I-) zu einer Zelle entsprechend einem Vier-Draht-Meßverfahren. Die Bezeichnungen K1, K2, etc. beschreiben je einen Kanal der Meß- und Steuerelektronik bzw. eine Zelle oder einen Zellsimulator.

Alle Zellen oder Zellsimulatoren eines Formationstrays 11 werden systembedingt über die Kontaktiereinheit 10 immer gleichzeitig kontaktiert.

Figur 3B und 3C veranschaulichen die Notwendigkeit, jeden Kanal einzeln zu testen und Zellsimulatoren mit unterschiedlichem Verhalten zu verwenden. Werden die Meßleitungen (U+, U-) und/oder die Stromleitungen (I+, I-) eines Kanals paarweise mit den Meßleitungen eines anderen Kanals vertauscht, so kann der Fehler nur erkannt werden, wenn jeweils nur ein Kanal aktiv ist, also Strom führt und benachbarte Zellsimulatoren unterschiedliches Verhalten aufweisen. Da die Anordnung oder Reihenfolge der unterschiedlichen Zellsimulatoren bekannt ist, ist auch der erwartete Meßwert für jeden einzelnen Kanal bekannt. Somit können die oben genannten Fehler entdeckt werden.

Figur 3D zeigt die Notwendigkeit des unterschiedlichen Verhaltens der Zellsimulatoren bei inverser Polarität.

Figur 3E und 3F zeigen weitere mögliche Fehler, die vom erfindungsgemäßen Verfahren erkannt werden.

Die unterschiedlichen Zellsimulatoren müssen so ausgestaltet werden, daß sie sich unter Berücksichtigung aller Bauteil- und Meß-Toleranzen deutlich voneinander und vom Verhalten bei inverser Polarität unterscheiden. Bei Verwendung von beispielsweise vier unterschiedlichen Zellsimulatoren könnte der Spannungsabfall bei Stromfluß durch den jeweiligen Zellsimulator 2,7 V; 3,3 V; 3,9 V bzw. 4,7 V und bei inverser Polarität 1,0 V betragen.

Diese vier verschiedenen Typen an Zellsimulatoren unterscheiden sich im Wert des eingesetzten Widerstandes, z. B. 27, 33, 39 und 47 Ohm. Sie werden nacheinander und sich regelmäßig wiederholend im Formationstray angeordnet.

Der Prüfstrom und der Wert der Widerstände R müssen so gewählt werden, daß der resultierende Spannungsabfall wesentlich größer als die Flußspannung der Diode ist, also beispielsweise 1,0 V. Gleichzeitig muß aber gewährleistet sein, daß die resultierende Spannung noch im zulässigen Meß- und Regelbereich der Steuerung liegt.
- z. B.:: Widerstand R: 27 / 33 / 39 / 47 Ohm
Flußspannung Diode D: 1,0 V
Meß- und Regelbereich Steuerung: 0 bis 5,5 V
Prüfstrom: 100 mA
=> mit U = R * I resultiert ein Spannungsabfall von: 2,7 / 3,3 / 3,9 / 4,7 V

Der zu prüfende Kanal der Meß- und Steuerelektronik wird aktiviert, d. h. ein definierter Strom eingeprägt. Alle anderen Kanäle werden deaktiviert, d. h. es fließt kein Strom. Nach Ablauf einer kurzen Einschwingzeit wird der Strom gemessen und geprüft, ob der gemessene Wert im vorgegebenen Toleranzfenster liegt. Ist dies nicht der Fall, so ist der Testkanal und/oder die zugehörige Verdrahtung nicht in Ordnung. Ansonsten wird die Prüfung mit dem Messen der resultierenden Spannung am Zellsimulator fortgesetzt. Der gemessene Wert wird mit dem für diesen Zellsimulatortyp vorgegebenen Wert oder Toleranzfenster verglichen. Liegt der Wert außerhalb, so ist der Testkanal und/oder die zugehörige Verdrahtung nicht in Ordnung. Dieser Ablauf wird für alle zu prüfenden Kanäle wiederholt.

Es ist grundsätzlich nur ein Kanal der Steuerung aktiv. Alle anderen Kanäle sind deaktiviert, d. h. hochohmig. Über die Steuerung wird der jeweils aktive Kanal mit einem Konstantstrom von z. B. 100 mA beaufschlagt. Nach Ablauf einer Einregelzeit (z. B. 17 Sek.) mißt die Steuerung die Zellspannung und den Strom und überprüft, ob beide Werte im zulässigen Bereich liegen. Um ein evtl. vorhandenes Schwingen zu erkennen, wird diese Messung und Prüfung nach weiteren 3 bzw. 7 Sekunden wiederholt.

Der zulässige Wertebereich für die Spannung wird aus der Toleranz des Widerstandes auf dem Zellsimulator, der Spannungs-Meßungenauigkeit der Steuerung, sowie der Ungenauigkeit der Stromregelung berechnet. Der zulässige Wertebereich für den Strom ergibt sich durch die Ungenauigkeit der Stromregelung. Werte und Toleranz der Widerstände müssen so gewählt werden, daß sich die resultierenden zulässigen Bereiche nicht überschneiden.

Die oben beschriebene Vorgehensweise wird nacheinander für alle Zellpositionen im Formationstray wiederholt.

Gemäß der Erfindung ist ein Zellsimulator in der gleichen Form und Größe wie die zu prüfende Batterie vorhanden, auf oder in dem eine Prüfelektronik integriert ist. Es können Formationstrays mit solchen Zellsimulatoren gefüllt werden, so daß der komplette Satz Anschlüsse in einer Messung geprüft werden kann.

Wenn die Zellsimulatoren in systematisch abgestufter Leitfähigkeit eingesetzt werden, kann auch eine Vertauschung in der Verschaltung benachbarter Plätze erkannt werden. Bei Verwendung einer Prüfelektronik bestehend aus Widerstand und parallel geschalteter Diode kann auch eine vertauschte Polarität detektiert werden. Da die Messung computergesteuert stattfindet, kann eine Fehlermeldung mit genauer Fehlerbeschreibung erfolgen.

Als Prüfobjekt kann auch ein Behälter mit festmontierten Zellsimulatoren verwendet werden, der automatisch in definierten zeitlichen Abständen durch die Anlage geschickt wird.

Damit kann aufwendige und teure Handarbeit unter schwierigen Bedingungen entfallen, die Zuverlässigkeit der Prüfung ist höher.

Das erfindungsgemäße Verfahren und die zugehörige Vorrichtung ermöglichen die Detektierung der Unterbrechung einer oder mehrerer Leitungen, da entweder kein Strom fließen kann und/oder eine falsche Spannung gemessen wird. Erkannt werden kann auch die Verpolung einer oder mehrerer Leitungen pro Zelle. Die auf dem Zellsimulator parallel zum Widerstand in Sperrichtung geschaltete Diode wird leitend, und die gemessene Spannung ist gleich der Flußspannung der Diode, da diese wesentlich kleiner ist als die erwartete Spannung.

Dadurch, daß immer nur ein Kanal gleichzeitig aktiviert wird und benachbarte Zellsimulatoren unterschiedliche Widerstände haben, wird das Vertauschen einer oder mehrerer Leitungen einer Zelle mit den Leitungen einer oder mehrerer benachbarter Zellen erkannt.

Schlechter elektrischer Kontakt in Steckverbindern oder zwischen Kontaktiereinheit und Zelle führt, da hier das Vier-Draht-Meßverfahren angewandt wird, nur dann zu Problemen, wenn der dadurch resultierende Übergangswiderstand so groß wird, daß die Steuerung die Spannung nicht mehr nachregeln kann. In diesem Fall liegen die von der Steuerung gemessenen Werte außerhalb der Toleranz, und der Fehler wird somit vom Prüfverfahren erkannt.

Ist einer oder mehrere Kanäle der Steuerelektronik defekt, oder liegt die Meß- und/oder Regelgenauigkeit eines oder mehrerer Kanäle der Steuerelektronik außerhalb der Toleranz, liegen die gemessenen Werte nicht im zulässigen Bereich.

Bei einem Ausführungsbeispiel beinhaltet die Erfindung ein Verfahren zur Fehlersuche in automatisch arbeitenden elektronischen Meß- und Prüf-Anordnungen für eine Vielzahl von galvanischen Elementen. Es werden in die für die galvanischen Elemente vorgesehenen Halterungen Zellsimulatoren eingesetzt. Diese Zellsimulatoren simulieren in äußerer Form und Größe einschließlich der elektrischen Anschlüsse ein galvanisches Element. Sie enthalten eine Prüfelektronik, deren Verhalten sich bei inverser Polarität stark vom Verhalten bei anwendungsrichtiger Polarität unterscheidet. Ein Zellsimulator wird aktiviert und mit einem Meßstrom beaufschlagt. Anschließend wird die Spannung bzw. Spannungsantwort am Zellsimulator gemessen und mit dem für diesen Zellsimulatorvorgegebenen Sollspannungswert verglichen. Die Prüfelektronik besteht zumindest aus der Parallelschaltung eines Widerstands und einer Diode.

## Patentansprüche

1. Verfahren zur Fehlersuche in automatisch arbeitenden elektronischen Meß- und Prüf-Anordnungen für eine Vielzahl von galvanischen Elementen, wobei an den Meß- und Prüf-Anordnungen Halterungen für die galvanischen Elemente vorgesehen sind, **dadurch gekennzeichnet, daß**
- in die Halterungen Zellsimulatoren (9) eingesetzt werden, die in äußerer Form und Größe einschließlich der elektrischen Anschlüsse in etwa ein galvanisches Element nachbilden und die eine Prüfelektronik enthalten, wobei sich das Verhalten der Zellsimulatoren bei inverser Polarität stark vom Verhalten bei anwendungsrichtiger Polarität unterscheidet,
- ein Zellsimulator (9) aktiviert und mit einem Meßstrom beaufschlagt wird und
- anschließend die Spannung am Zellsimulator (9) gemessen und mit dem für diesen Zellsimulator vorgegebenen Sollspannungswert verglichen wird.

2. Verfahren nach Anspruch 1, **dadurch gekennzeichnet, daß** vor der Spannungsmessung am Zellsimulator (9) der Meßstrom in vorgegebenen Zeitabschnitten mit dem vorgegebenen Sollwert verglichen wird.

3. Verfahren nach Anspruch 1 oder 2, **dadurch gekennzeichnet, daß** mehrere Zellsimulatoren (9) benachbart angeordnet werden, wobei vorzugsweise benachbarte Zellsimulatoren jeweils unterschiedliches Verhalten aufweisen.

4. Vorrichtung zur Fehlersuche in automatisch arbeitenden elektronischen Meß- und Prüf-Anordnungen für eine Vielzahl von galvanischen Elementen, **dadurch gekennzeichnet, daß** sie in äußerer Form und Größe einschließlich der elektrischen Anschlüsse in etwa ein galvanisches Element nachbildet und eine Prüfelektronik (6, 7) enthält, deren Verhalten sich bei inverser Polarität stark vom Verhalten bei anwendungsrichtiger Polarität unterscheidet.

5. Vorrichtung nach Anspruch 4, **dadurch gekennzeichnet, daß** die Prüfelektronik zumindest eine Parallelschaltung eines Widerstands (7) und einer Diode (6) aufweist.

6. Vorrichtung nach Anspruch 4 oder 5, **dadurch gekennzeichnet, daß** sie als Zellsimulator (9) ausgebildet ist, wobei sie in den für die Aufnahme einer Vielzahl von zu prüfenden galvanischen Elementen bestimmten Halterungen eines Prüf- oder Formationstrays (11) angeordnet ist.

7. Vorrichtung nach Anspruch 6, **dadurch gekennzeichnet, daß** benachbarte Zellsimulatoren (9) unterschiedliche Impedanzen besitzen für eine unterschiedliche Spannungsantwort bei Beaufschlagung mit einem Meßstrom.

8. Vorrichtung nach einem der Ansprüche 4 bis 7, **dadurch gekennzeichnet, daß** sie zur Durchführung des Verfahrens nach einem der Ansprüche 1 bis 3 ausgebildet ist.
